(19) Europäisches Patentamt
European Patent Office
Office européen des brevets

(11) **EP 1 256 159 B1**

(12) **EUROPÄISCHE PATENTSCHRIFT**

(45) Veröffentlichungstag und Bekanntmachung des Hinweises auf die Patenterteilung:
**09.07.2008 Patentblatt 2008/28**

(21) Anmeldenummer: **01913529.2**

(22) Anmeldetag: **23.01.2001**

(51) Int Cl.:
*H02K 3/14* *(2006.01)*          *H02K 15/04* *(2006.01)*
*H02K 55/00* *(2006.01)*

(86) Internationale Anmeldenummer:
**PCT/DE2001/000263**

(87) Internationale Veröffentlichungsnummer:
**WO 2001/059909 (16.08.2001 Gazette 2001/33)**

(54) **VOLLTRANSPONIERTER HOCH-T C?-VERBUNDSUPRALEITER SOWIE VORRICHTUNG ZU DESSEN HERSTELLUNG UND DESSEN VERWENDUNG**

FULLY TRANSPOSED HIGH T C? COMPOSITE SUPERCONDUCTOR, METHOD FOR PRODUCING THE SAME AND ITS USE

SUPRACONDUCTEUR COMPOUND A HAUT T C? ENTIEREMENT TRANSPOSE ET DISPOSITIF POUR SA FABRICATION ET SON UTILISATION

(84) Benannte Vertragsstaaten:
**AT BE CH CY DE DK ES FI FR GB GR IE IT LI LU MC NL PT SE TR**

(30) Priorität: **14.02.2000 DE 10006473**

(43) Veröffentlichungstag der Anmeldung:
**13.11.2002 Patentblatt 2002/46**

(73) Patentinhaber: **SIEMENS AKTIENGESELLSCHAFT**
**80333 München (DE)**

(72) Erfinder:
• **ALBRECHT, Cord**
  **91058 Erlangen (DE)**
• **MASSEK, Peter**
  **91301 Forchheim (DE)**
• **KUMMETH, Peter**
  **91074 Herzogenaurach (DE)**

(56) Entgegenhaltungen:
EP-A- 0 407 709          EP-A- 0 623 937
GB-A- 1 572 236          US-A- 4 611 390

**Beschreibung**

Die Erfindung bezieht sich auf einen volltransponierten Verbundsupraleiter mit zumindest annähernd rechteckigem Querschnitt, der mehrere nach Art eines Roebelstabes zusammengefasste Teilleiter enthält, welche jeweils

- einen zumindest annähernd rechteckigen Querschnitt mit einer Breite B,
- mindestens einen Leiterkern aus einem Hoch-$T_c$-Supraleitermaterial in einer Matrix und/oder Umhüllung aus normalleitendem Material sowie
- bezüglich eines seitlichen Biegens in der Ebene der Breite B einen vorbestimmten Biegeradius und eine vorbestimmte Biegezonenlänge

aufweisen. Ein entsprechender Verbundsupraleiter geht aus "IEEE Transactions on Applied Superconductivity", Vol. 9, No. 2, Juni 1999, Seiten 111 bis 121 hervor. Die Erfindung betrifft ferner eine Vorrichtung zur Herstellung dieses Verbundsupraleiters sowie dessen Verwendung.

Eine energietechnische Anwendung von Hoch-$T_c$-Supraleitern (nachfolgend als HTS-Leiter abgekürzt) z.B. zur Realisierung von Transformator- oder Maschinenwicklungen erfordert verlustarme Leiter mit Wechselstrom-Nennwerten bis in den Kilo-Ampere-Bereich. Zur Verfügung stehen zur Zeit jedoch nur HTS-Bandleiter geringen Querschnitts und mit Stromtragfähigkeitswerten von etwa 50 bis 100 $A_{eff}$ bei 77 K im magnetischen Eigenfeld. Zudem sind diese Bandleiter mechanisch sehr empfindlich, und deren elektrische Eigenschaften hängen stark von Betrag und Richtung des lokalen Magnetfeldes, in dem sie sich befinden, ab.

Aus diesen Gründen sieht man sich gezwungen, technisch einsetzbare Hochstrom-Supraleiter aus vielen einzelnen, parallelen Bandleitern in Form von sogenannten Verbundleitern z.B. gemäß der DE 27 36 157 B2 aufzubauen, wobei nach einer möglichst kontinuierlichen, anwendungsfertigen Ausbildung getrachtet wird. Für Wechselstromanwendungen im Rahmen von Industriefrequenzen (im allgemeinen bis 60 Hz) müssen außerdem die nachfolgend als Teilleiter oder Einzelleiter bezeichneten Bandleiter solcher Verbundleiter gegeneinander isoliert und systematisch transponiert bzw. verdrillt werden, um eine gleichmäßige Stromverteilung im Gesamtquerschnitt und damit geringe Wechselstromverluste zu gewährleisten.

Transponierte Verbundleiter mit hoher Wechselstromtragfähigkeit sind prinzipiell bekannt. Sie können folgendermaßen ausgeführt sein:

- Als sogenannte "Leiterstäbe", z.B. in Form von Roebel-, Schränk- oder Gitterstäben, mit Teilleitern aus Kupfer z.B. für große Wechselstrommaschinen,
- als sogenannte "Drill-Leiter" mit Teilleitern aus Kupfer für Transformatoren oder Drosseln,
- als sogenannte transponierte "Flach- oder Rundleiter" mit Teilleitern aus metallischen Supraleitern wie z.B. NbTi in Cu (vgl. die genannte DE 27 36 157 B2).

Auch ein Transponieren von HTS-Leitern zur Erhöhung einer Wechselstromtragfähigkeit ist bekannt. Diesbezügliche konkrete Auslegungsbetrachtungen und Konstruktionshinweise beziehen sich

- auf ein kontinuierliches Transponieren von runden oder praktisch runden HTS-Teilleitern in Einfach- oder Mehrfach-Seilen (vgl. z.B. sogenanntes "Rutherford Cable" in "IEEE Transactions on Applied Superconductivity", Vol.7, No. 2, Juni 1997, Seiten 958 bis 961),
- auf ein Erreichen eines kontinuierlichen Transpositionseffektes in Energiekabeln durch Variation der Steigung verseilter bandförmiger HTS-Teilleiter von Leiterschicht zu Leiterschicht (sogenanntes "Pitch Adjustment"; vgl. WO 96/39705),
- auf das sogenannte "In-situ"-Transponieren, d.h. das schrittweise Transponieren während der Wicklungsherstellung direkt auf dem Wickelkörper, z.B. einer Transformatorwicklung (vgl. z.B. "IEEE Transactions on Applied Superconductivity", Vol.7, No.2, Juni 1997, Seiten 298 bis 301).

Aus der eingangs genannten Literaturstelle aus "IEEE Transactions on Applied Superconductivity" geht der prinzipielle Aufbau eines volltransponierten Verbundsupraleiters aus HTS-Teilleitern nach Art eines Roebelstabes hervor. Der gezeigte Verbundsupraleiter ist dabei aus Teilleitern nach Konzepten zusammengesetzt, wie sie mit Teilleitern aus klassischen Supraleitermaterialien wie z.B. NbTi realisiert werden. Es zeigt sich jedoch, dass bei einem derartigen Aufbau nur eine verhältnismäßig geringe Stromtragfähigkeit des gesamten Verbundleiters zu erreichen ist.

In GB 1572236 und US 4 611 390 sind zusätzliche volltransponierte supraleiter beschrieben worden.

Aufgabe der vorliegenden Erfindung ist es deshalb, den Verbundsupraleiter mit den eingangs genannten Merkmalen dahingehend auszugestalten, dass er gegenüber diesem Stand der Technik eine vergleichsweise höhere Stromtragfähigkeit besitzt. Dabei sollen die ursprüngliche Stromtragfähigkeit seiner einzelnen bandförmigen Teilleiter optimal auszunutzen und die Risiken zu minimieren sein, die aus der mechanischen Empfindlichkeit und der elektrischen Anisotropie der Teilleiter herrühren. Der Verbundsupraleiter soll in praktisch beliebiger Länge herzustellen sein.

Diese Aufgabe wird erfindungsgemäß dadurch gelöst, dass für jeden der Teilleiter der Biegeradius R größer als das 100fache der Breite B sowie die Biegezonenlänge H größer als das 20fache der Breite B ist und dass Mittel zur Fixierung der Teilleiter untereinander vorgesehen sind.

Bei den erfindungsgemäßen Maßnahmen wird von der Überlegung ausgegangen, dass beim Aufbau des Verbundsupraleiters nach Art eines Roebelstabes aus mehreren insbesondere vollisolierten, volltransponierten HTS-Bandleitern als Teilleitern die notwendigen laufenden Kröpfungen bzw. Hochkantbiegungen und Flachbiegungen der Teilleiter kritische Biegeradienwerte nicht unterschreiten dürfen. Es wurde erkannt, dass mit der erfindungsgemäßen gleichzeitigen Wahl des Biegeradius und der Biegezonenlänge in Abhängigkeit von der Teilleiterbreite Beschädigungen der supraleitenden Leiterkerne der Teilleiter beim Biegen zur Ausbildung des Roebelstabaufbaus, d.h. bei der sogenannten "Verroebelung" vermieden werden. Dabei sind mit der erfindungsgemäßen Wahl der vorgenannten beiden Größen die Biegeradien für das bei der Verroebelung erforderliche Biegen auch um die Flachseiten ohne weiteres einzuhalten und liegen in üblichen Größenordnungen. So kann dann vorteilhaft jeder Teilleiter additiv zur Stromtragfähigkeit des gesamten Verbundsupraleiters in hohem Maße beitragen. Da die Biegezonenlänge H wesentlich größer ist als bei einem von klassischen Supraleitern her bekannten Aufbau gemäß dem genannten Stand der Technik, ergibt sich ein verhältnismäßig lockerer Verbund, der Mittel zur Fixierung der Teilleiter untereinender und damit des gesamten Verbundleiters erforderlich macht. Diese Fixierungsmittel sind unter dem Gesichtspunkt einer weiteren Verarbeitung des Verbundsupraleiters zu wählen.

Erfindungsgemäße Verbundsupraleiter zeichnen sich deshalb vorteilhaft durch eine hohe Stromtragfähigkeit und eine großtechnische Herstellungsmöglichkeit insbesondere hinsichtlich großer Leiterlängen aus.

Vorteilhafte Ausgestaltungen des erfindungsgemäßen Verbundsupraleiters gehen aus den von Anspruch 1 abhängigen Sachansprüchen hervor.

In Hinblick auf eine Minimierung der Gefahr einer Stromdegradation des erfindungsgemäßen Verbundsupraleiters wird vorteilhaft für die Teilleiter ein Biegeradius R von mindestens dem 150-Fachen der Breite B und/oder eine Biegezonenlänge H von mindestens dem 50-Fachen der Breite B vorgesehen.

Prinzipiell ist es möglich, für den Aufbau erfindungsgemäßer Verbundsupraleiter unterschiedliche Teilleiter, z.B. mit und ohne Supraleitermaterial, und/oder mit verschiedenem Querschnitt zu verwenden.Im Hinblick auf eine gleichmäßige Stromverteilung über den gesamten Verbundleiterquerschnitt ist es jedoch von Vorteil, wenn eine Zusammenfassung von Teilleitern mit gleichem Aufbau vorgesehen wird.

Für den erfindungsgemäßen Verbundsupraleiter kommen als Fixierungsmittel Verklebungen oder Verlötungen der Teilleiter untereinander in Frage. Vorzugsweise wird eine Bandagierung oder Umspinnung vorgesehen, um dem Verbundsupraleiter eine hinreichende Flexibilität zu verleihen. Dabei kann im Hinblick auf eine eventuelle spätere Inmprägnierung mit einem Kunstharz oder auf einen guten Kühlmittelzutritt die Bandagierung oder Umspinnung insbesondere entsprechend transparent oder saugfähig ausgeführt sein.

Vorteilhaft wird der Verbundsupraleiter mit Teilleitern aufgebaut, die jeweils ein Verhältnis ihrer Breite B zur jeweiligen Leiterdicke D zwischen 5 und 40, vorzugsweise zwischen 10 und 20 aufweisen. Entsprechende Teilleiter , die kommerziell gefertigt werden, sind besonders zu einer Verroebelung unter Einhaltung der genannten Mindestwerte geeignet.

Im Hinblick auf eine Verringerung der Wechselstromverluste bei einem Einsatz erfindungsgemäßer Verbundsupraleiter werden sie vorteilhaft mit Teilleitern aufgebaut, von denen zumindest einige gegenseitig elektrisch isoliert sind.

Derartige Verbundsupraleiter sind folglich insbesondere in einer energietechnischen Einrichtung mit Wechselstrombetrieb wie z.B.in einem Transformator oder einer elektrischen Maschine zu verwenden.

Zu einer quasi kontinuierlichen Herstellung eines erfindungsgemäßen Verbundsupraleiters wird vorteilhaft eine Vorrichtung vorgesehen, die Mittel zu einem reusenartigen Zusammenführen der einzelnen Teilleiter von Vorratsspulen über einen Biegebereich und einen Führungsbereich in einer Verroebelungszone derart besitzt, dass die Leiterquerschnittslage zumindest weitgehend konstant, beispielsweise horizontal bleibt, und die Mittel zum Transport des nunmehr verroebelten Aufbaus über eine Vorschubeinheit und einen Fixierungsbereich in eine Aufwickelspule aufweist. In dem Fixierungsbereich erfolgt vorzugsweise eine Bandagierung oder Umspinnung des Leiteraufbaus. Mit einer solchen Vorrichtung lassen sich vorteilhaft die Grundforderungen an eine HTS-Roebelleiter-Herstellung erfüllen. Insbesondere ist der Unvermeidbarkeit der HTS-typischen sehr langen Biegezonen zu entsprechen durch eine funktionelle Trennung und örtliche Hintereinanderverteilung der Schritte "Lagesteuerung", "Halten", "Biegen", "Versetzen" und "Zusammenfassen" bzw. "Kombinieren".

Vorteilhaft können die Vorratsspulen der Vorrichtung an einer Drehscheibe drehbeweglich befestigt sein.

In der Vorrichtung erfolgt die Zuführung der Teilleiter in die Verroebelungszone vorteilhaft mittels einer rotierenden Schlitzführungsscheibe. In der Verroebelungszone können dabei vorteilhaft feststehende Führungselemente und ein Roebelkanal vorhanden sein.

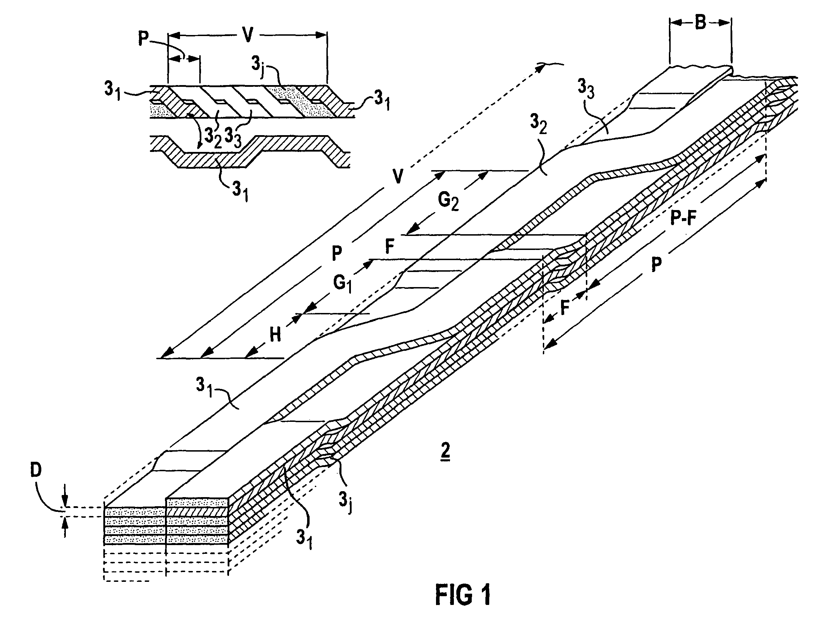

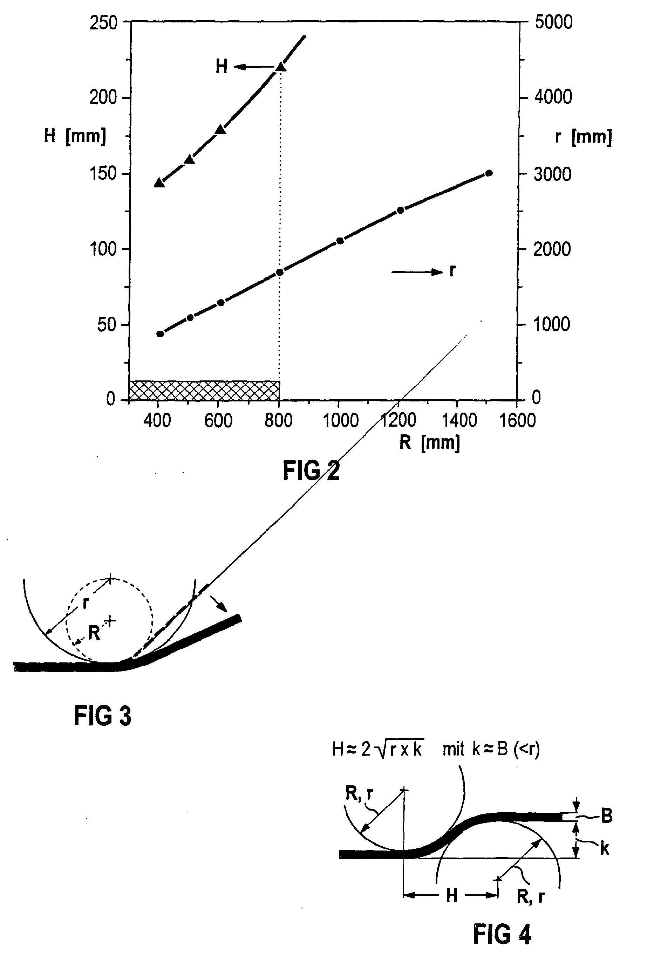

Die Erfindung wird nachfolgend an Hand der Zeichnung noch weiter erläutert. Dabei zeigen jeweils schematisch

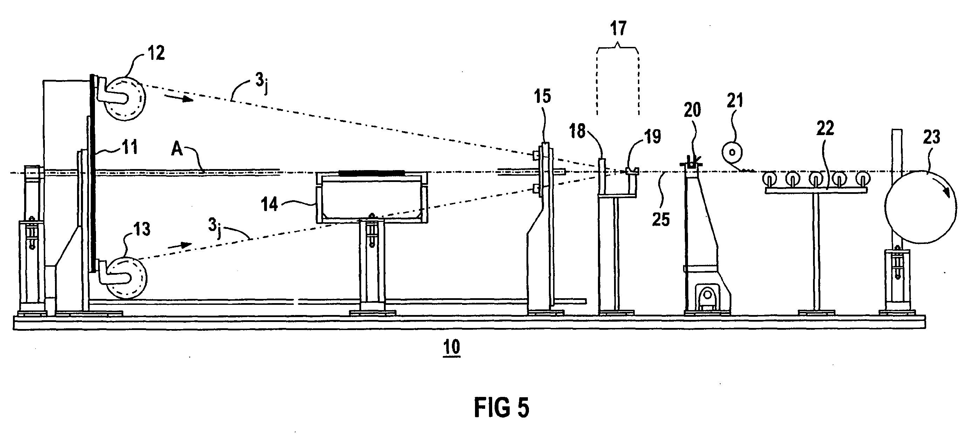

deren Figur 1     den Aufbau eines volltransponierten Verbundsupraleiters nach der Erfindung,

deren Figur 2     in einem Diagramm die Biegezonenlänge und den bleibenden Biegeradius in Abhängigkeit von dem angewandten Biegeradius bei der Herstellung erfindungsgemäßer Verbundleiter,

deren Figuren     3 und 4 Biegeradien für die dem Diagramm der Figur 2 zu Grunde gelegte Herstellung, und

deren Figur 5     eine Vorrichtung zur Herstellung dieses Leiters.

In den Figuren sind sich entsprechende Teile mit denselben Bezugzeichen versehen.

Bei dem in Figur 1 in Schrägansicht dargestellten Ausschnitt aus einem erfindungsgemäßen, allgemein mit 2 bezeichneten Verbundsupraleiter wird von an sich bekannten Ausführungsformen solcher Leiter ausgegangen, die mehrere nach Art eines Roebelstabes zusammengefasste Teilleiter $3_j$ enthalten (j = Anzahl der Teilleiter mit $1 \leq j \leq N$). Als Basisveröffentlichung einer Verroebelung sei auf die DE-PS 277 012 verwiesen. N Teilleiter $3_j$ brauchen dabei mehr als N + 1 Rasterplätze. In der Figur 1 bedeuten

F     Flachbiegezone

$G_{1,2}$     Gerade, nicht-gebogene Stücke

H     Hochkant-Biegezone

P     periodischer Hochkant-Biegezonenabstand

V     Volltranspositionslänge

D     Teilleiterdicke

B     Teilleiterbreite.

Die genannten Größen sind dabei wie folgt miteinander verknüpft:

$$P = H + G_1 + F + G_2$$

und

$$V = N \times P \text{ (mit } „x" = \text{Multiplikationssymbol)}.$$

Figur 1 zeigt ferner eine Draufsicht auf einen Ausschnitt aus diesem Verbundsupraleiter 2 sowie einen Ausschnitt aus einem einzigen Teilleiter ($3_1$) aus dieser Draufsicht.

Bei den Teilleitern $3_j$ handelt es sich um bekannte bandförmige Ein- oder Mehrkern-HTS-Leiter mit rechteckigem Querschnitt, wobei vorzugsweise alle Teilleiter gleich gestaltet sind und jeder Teilleiter dieselbe Leiterbreite B hat. Bei den Teilleitern kann es sich insbesondere um bekannte Ausführungsformen handeln, die im allgemeinen folgende Merkmale und Eigenschaften aufweisen:

-     <u>Geometrie und Struktur</u>: Sie haben kleine, flache Querschnitte (typisch um 1 mm$^2$) mit sehr geringer Dicke (typisch zwischen 0,2 mm und 0,5 mm ; Breite bis ca. 4 mm). Von den verschiedenen existierenden Ausführungsformen kommen für den hier ins Auge gefassten Anwendungsbereich vorzugsweise sogenannte Multifilamentsupraleiter (mit mehreren supraleitenden Leiterkernen) in Frage: Das supraleitende keramische Material ist in Form feiner Filamente eingebettet in eine insbesondere aus Silber oder einer Silberlegierung bestehenden Matrix. Die Filamente sind dabei vorzugsweise verdrillt (zur Herabsetzung von Wechselstrom-Verlusten). Als Supraleitermaterial gut geeignet ist die HTS-Vielstoffverbindung vom Typ $(Bi,Pb)_2Sr_2Ca_2Cu_3O_x$ (sogenanntes "BPSCCO-2223-Material"). Die Silbermatrix kann zweckmäßigerweise durch eine zusätzliche dünne Hülle z.B. aus einer Silber-Magnesium-Legierung verstärkt sein. Ein entsprechender, für die nachfolgenden Betrachtungen an Hand der Figuren 2 bis 4 zu Grunde gelegter konkreter HTS-Standardbandleiter ist aus "IEEE Transactions on Applied Superconductivity", Vol. 9, No. 2, Juni 1999, Seiten 2480 bis 2485 bekannt. Er besitzt eine von einer AgMg-Hülle umgebene Ag-Matrix mit 55 darin eingelagerten, gegensetig vertwisteten Leiterkernen bzw.-filamenten aus dem BPSCCO-2223-HTS-Material. Seine Außendimensionen (ohne Isolation) sind 3,6 x 0,26 mm$^2$. Er kann noch von einer Isolation z.B. aus Lupolen mit einer Dicke zwischen 0,03 und 0,05 mm umgeben sein.

-     <u>Mechanische Empfindlichkeit</u> gegen plastische Verformung: Zulässige Randfaserdehnungen bei Streckung, Biegung oder Torsion liegen $\leq 0,2$ %, kritische Biegeradien typisch bei 50 mm (flache Seite) bzw. 800-1000 mm (Hochkantbiegung).

- <u>Anisotropie:</u> Zu beobachten ist eine ausgeprägte Magnetfeldrichtungsabhängigkeit ihrer Stromtragfähigkeit. So sinkt z.B. der bei 0,3 T und 77 K transportierbare Strom auf etwa ein Fünftel, wenn man die Feldrichtung aus der Leiterebene in die Richtung senkrecht zur flachen Leiterseite dreht.

Der dargestellte HTS-Hochstrom-Verbundleiter 2 ist durch folgende Hauptmerkmale gekennzeichnet:

1. Der Verbundleiter ist aus mehreren, vorzugsweise voll isolierten HTS-Bandleitern als Teilleitern $3_j$ zusammengesetzt. Die notwendige Anzahl N der Teilleiter mit einem Nennstrom $I_{HTSn}$ für einen gewünschten Nennstrom $I_{VLn}$ des Verbundsupraleiters ergibt sich nicht einfach als Quotient $I_{VLn} / I_{HTSn}$. Sie ist meistens deutlich größer und konkret nur mit Hilfe der materialspezifischen, nichtlinearen I(B)-Kurven und für einen bestimmten Anwendungsfall zu bestimmen, da $I_{HTSn}$ für einen gestreckten Bandleiter im Eigenfeld definiert ist, $I_{VLn}$ dagegen für die lokalen Feldwerte am Ort der Anwendung. Bereits bei einem gestreckten Verbundleiter ohne äußeres Magnetfeld bewirkt das durch die jeweils benachbarten Teilleiter erhöhte Feld am Ort eines jeden Teilleiters eine Erniedrigung seiner Stromtragfähigkeit.

2. Die Teilleiter $3_j$ werden innerhalb des Verbundleiter-Gesamtquerschnitts systematisch und fortlaufend transponiert (Prinzip Roebel-Stab: laufende Kröpfungen durch Hochkantbiegungen und Flachbiegungen im Wechsel).

3. Beim Transponieren dürfen die Teilleiter nur reine Transversal-Versetzungen erfahren, jedoch - im Unterschied zum Verseilen - keinerlei Drehung, Torsion oder Kippung. Damit würde die Ausrichtung der Teilleiter auf die günstigste Feldrichtung verlassen, die Stromtragfähigkeit stark sinken (Anisotropie).

4. Für die genannten Teilleiter-Biegungen sind in beiden Querrichtungen unterschiedliche kritische Biegeradien maßgebend, die im Rahmen der erfindungsgemäß vorgegebenen Werte leiterspezifisch zu ermitteln sind. Bei Unterschreiten dieser Werte degradiert die Stromtragfähigkeit der betroffenen HTS-Bandleiter. Die kritischen Radien sind jeweils etwa um den Faktor 100 größer als bei querschnittsgleichen Kupferbändern. In dem Diagramm der Figur 2 ist ein kritischer Bereich des Biegeradius R (unter 800 mm) des bekannten, als Teilleiter verwendeten HTS-Standardbandleiters mit einer unerwünschten Überdehnung seiner supraleitenden Leiterfilamente und folglich einer Stromdegradation durch eine Kreuzschraffur angedeutet. - Außerdem federt, wie in Figur 3 angedeutet ist, das bekannte HTS-Leiterband nach dem Biegen etwa um den Faktor 2 auf; d.h., man muss zwischen dem angewandten Biegeradius R (am Werkzeug) und dem bleibenden, größeren Biegeradius r (im Verbundsupraleiter) unterscheiden. Typische Werte zum realen Biegeverhalten des kommerziellen HTS-Standardbandleiters sind in dem Diagramm der Figur 2 festgehalten.

5. Wie ferner aus dem Diagramm der Figur 2 unter Zugrundelegung der in den Figuren 3 und 4 definierten Größen R, r, k (für eine seitliche, etwa S-förmige Kröpfung bzw. Biegung) und H hervor geht, sind bei dem zu Grunde gelegten konkreten HTS-Standardbandleiter die HTS-typischen hohen Werte für die zulässigen Biegeradien R bzw. r mit verhältnismäßig langgestreckten Übertritts- bzw. Kröpfzonen H (= Biegezonenlänge bezüglich eines seitlichen Biegens in der Ebene der Teilleiterbreite B) der N Teilleiter korreliert. Dies kann gegebenenfalls zu großen Biegezonen-Abständen P und großen Volltranspositionslängen V = N x P im Verbundsupraleiter führen, die bei anderen Parametern des Verbundleiters wie z.B. bei der Anzahl N berücksichtigt werden müssen.

6. Die vorstehend unter 5. angesprochenen langgestreckten Biegezonen der Teilleiter haben im Gesamtleiter zunächst einen lockeren Verbund und erhebliche Probleme bei der Einhaltung von Querschnittstoleranzen zur Folge. Beides bringt Schwierigkeiten für die Wicklungsherstellung mit sich. Dem muss durch eine geeignete Fixierung vorzugsweise in Form einer Außenbandage oder Umspinnung auf dem oder um den Aufbau aus den einzelnen Teilleitern entgegengewirkt werden. Geeignet ist eine Außenbandage in diesem Sinne dann, wenn sie fest genug im Interesse enger Toleranzen aufgebracht ist, zugleich aber locker genug, um gleichmäßige innere Ausgleichsbewegungen der Teilleiter bei einem globalen Biegen des Verbundsupraleiters z.B. während einer Wicklungsherstellung zu ermöglichen. Für die Außenbandage ist vorzugsweise saugfähiges Gewebeband vorzusehen, da bei den meisten Anwendungen die spätere Wicklung mit Harz imprägniert wird, um eine Verfestigung der Wicklung gegen Betriebs- und Störkräfte zu erreichen.

7. Bei den oben angesprochenen inneren Ausgleichsbewegungen spielt zusätzlich eine hohe Glattheit und Gleitfähigkeit der Isolationsoberflächen der Teilleiter gegeneinander eine große Rolle,- eine Forderung, der durch Auswahl eines entsprechenden Isolierwerkstoffes Rechnung zu tragen ist. Das Einbringen von Gleitmitteln ist weniger vorteilhaft, da sie die Isoliereigenschaften beeinträchtigen und einer ggf. anzuwendenden Harz-Imprägnierung der fertigen Wicklung abträglich sind.

Die Herstellung des erfindungsgemäßen Verbundsupraleiters kann vorteilhaft mit einer Vorrichtung erfolgen, die in Figur 5 in Seitenansicht schematisch dargestellt ist. Diese allgemein mit 10 bezeichnete Vorrichtung umfasst insbesondere folgende Teile, nämlich

eine große, um eine Achse A drehbare Drehscheibe 11 mit Vorratsspulen 12 und 13 für Teilleiter $3_j$ , ein Doppel-Biegewerkzeug 14, eine rotierende Schlitzführungsscheibe 15, in einer Verroebelungszone 17 feststehende Führungselemente 18 und einen Roebelkanal 19, eine Schrittvorschubeinheit 20, einen Bandagierbereich 21, eine Freilaufstrecke 22 sowie einen Aufwickler 23.

Nachfolgend sind die Funktionen dieser Teile der Vorrichtung in der Reihenfolge des horizontalen Materialflusses aufgeführt:

1. Das Einbringen der bandförmigen HTS-Teilleiter $3_j$ in den Prozess geschieht über die individuell gebremsten Vorratsspulen 12, 13, - bei N Teilleitern des späteren Verbundsupraleiters also über N Vorratsspulen. Diese sind auf der großen, horizontal (in Prozessrichtung) gelagerten Drehscheibe 11 jeweils pendelnd und drehbar montiert, und zwar so, daß ihre Achslage quer zur Prozessrichtung auch bei Rotation der Drehscheibe und bei Abzug vom Bandmaterial immer erhalten bleibt.

2. Die Teilleiter $3_j$ werden - unter Rotation der großen Drehscheibe - reusenartig (d.h. auf einer gedachten Kegelmantelfläche), auf die eigentliche Verroebelungszone 17 zugeführt. Vor dieser Zone sorgt die mit gleicher Drehzahl rotierende Führungsscheibe 15 mit N einzelnen Schlitzführungen, deren Querachse stets horizontal gehalten wird, für eine präzise Vorausrichtung der Teilleiter für den Einlauf in die Verroebelungszone.

3. Zwischen der großen Drehscheibe 11 und Schlitzführungsscheibe 15 werden die Kröpfungen (sogenannte "Hochkant-S-Biegezonen") in dem ausgedehnten, speziellen Doppel-Biegewerkzeug 14 hergestellt, - im Unterschied zu herkömmlichen Lösungen weit vor dem eigentlichen Verroebeln.

4. Dies geschieht in einem Schritt-Prozess, und zwar teilleiterweise: bei jeweils angehaltenem Gesamtprozess wird das Doppelwerkzeug 14 in den Bereich der Leiter-"Reuse" zu einem Teilleiter gefahren, der Kröpfvorgang durchgeführt, das Doppelwerkzeug aus dem Reusenbereich wieder herausgefahren, die große Drehscheibe - und damit die Leiterreuse - um eine Teilung (360°/ N) weitergedreht, das Leitermaterial in Leiterlängsrichtung um eine S-Zonenlänge H weitergezogen und wieder angehalten, das Doppelwerkzeug in den Bereich des nächsten Teilleiters gefahren, der nächste Kröpf-Vorgang eingeleitet , usf.

5. Die Lage-Feinsteuerung der vorgekröpften Teilleiter, - nachdem sie die Schlitzführungsscheibe 15 passiert haben und kurz bevor sie zu einem gemeinsamen Aufbau 25 zusammengefasst werden - , wird durch eine spezielle Anordnung von einzelnen, feststehenden Führungselementen 18 besorgt mit dem Ziel, die gleichmäßige Verteilung auf einer gedachten Kreisbahn (Reusenquerschnitt) in eine paternosterartige Bahnverteilung zu überführen und dabei außerdem teilweise einen Phasenvor- bzw. -rücklauf der Teilleiter auf der Verteilungsbahn zu erzwingen. Dies ist nötig, um den zuverlässigen Seitenwechsel des jeweils obersten bzw. untersten Teilleiters im Verbundleiterquerschnitt vorzubereiten.

6. Das eigentliche Zusammenfassen bzw. Kombinieren der vorgekröpften und in ihrer Querschnittslage vor-ausgerichteten Teilleiter $3_j$ zu dem Aufbau 25 des Verbundsupraleiters vollzieht sich hier - im Takt des Schrittverfahrens - in dem einfachen Roebel-Kanal 19. (Bei herkömmlichen Anlagen für konventionelle Verbundleiter dagegen werden mehrere Teilschritte des Verroebelungsprozesses lokal zusammengefasst und verlaufen kontinuierlich: Halten, Biegen, Versetzen und Kombinieren der Teilleiter geschehen dort auf engem Raum in einem einzigen Aggregat, dem sogenannten "Roebel-Kopf".) Die Innenmaße des Kanalquerschnitts dieses Roebel-Kanals 19 entsprechen in etwa den angestrebten Außenmaßen des Verbundsupraleiters, seine Länge etwa dem 10- bis 20-Fachen der Verbundleiterbreite. Im Einlaufbereich sind alle Einlaufkanten des Kanals leicht angerundet.

7. Den Schritt-Vorschub des Leiteraufbaus 25 aus seinen Teilleitern besorgt die Vorschubeinheit 20 (Greifen - Ziehen und Längsverfahren des Aufbaus- Öffnen - Zurückfahren ohne Aufbau) unmittelbar nach dem Führungskanal in Wechselwirkung mit der voreingestellten Bremskraft der Vorratsspulen auf der Drehscheibe am Anfang der Vorrichtung.

8. Die Herstellung einer Außenbandage geschieht in der Vorrichtung in dem Bandagierbereich 21, - wiederum im Takt des Schrittverfahrens, bei Stillstand, gleich nach der Vorschubeinheit. Ein notwendiger Kompromiss zwischen Lockerheit und Kontursicherung des Leiterverbundes kann durch eine spezielle Maßnahme erreicht werden. So wird z.B. der Leiterstapel vorübergehend durch einen Zugstreifen aufgedickt (Breite etwa 1,7 x Teilleiterbreite, Länge etwa 1,5 x Biegezonenabstand nach Figur 1), der oben auf den Stapel aufgelegt, dann in die Bandage mit eingewickelt und anschließend wieder herausgezogen wird. Bandagiert wird hier vorzugsweise mit Glasgewebeband "auf Lücke", d.h. mit Abstand zwischen den Windungen des Bandes. Durch die Wahl der Streifendicke, des Bandabstandes und der Spannkraft beim Bandagieren lässt sich das Maß der Lockerheit des Verbundes einstellen. Beispielsweise kann zu einer Bandagierung eines Aufbaus 25 des Verbundsupraleiters aus 13 HTS-Standard-Bandleitern ein gleitfähiger, 6 mm breiter Zugstreifen aus Hostaphan von 0,35 mm Stärke und ein Gewebeband aus Glasseide von 6 mm Breite und 0,1 mm Dicke mit jeweils 9 mm Lücke gewickelt werden.

Die wesentlichen Merkmale des geschilderten Herstellungsverfahrens lassen sich auf maschinelle Bandagierverfahren als Teil einer industriellen Verroebelungsanlage übertragen.

9. Der fertig zusammengefasste Verbundsupraleiter 2 wird über die "Freilaufstrecke" 22 (z.B. über entsprechende Rollen) einer Aufspuleinrichtung in Form des Aufwicklers 23 am Ende der Vorrichtung 10 zugeführt. Der Aufwickler ist auf konstanten Gesamtleiterzug eingestellt, gleichermaßen bei Vorlauf, Rücklauf oder Stillstand. Die Freilaufstrecke ist immer notwendig zum Ausgleich lokaler Teilleiterverschiebungen im Inneren des Verbundes, verursacht durch den unvermeidlichen Übergang vom gestreckten in den gewickelten (gekrümmten) Zustand eines Verbundleiters. Aus dem Herstellungsprozess bzw. Wickelverhalten herkömmlicher transponierter Leiter ist bekannt, dass eine solche Freilaufstrecke mindestens einer Volltranspositionslänge entsprechen muss.

Eine Vorrichtung zur Herstellung einer transponierter-Leiter ist aus dem Dokument EP 0 407 709 bekannt.

**Patentansprüche**

1. Volltransponierter Verbundsupraleiter mit mindestens annähernd rechteckigem Querschnitt, der mehrere nach Art eines Roebelstabes zusammenfasste Teilleiter enthält, welche jeweils

   - einen zumindest annähernd rechteckigen Querschnitt mit einer Breite B,
   - mindestens einen Leiterkern aus einem Hoch-$T_c$-Supraleitermaterial in einer Matrix und/oder Umhüllung aus normalleitendem Material

   sowie

   - bezüglich eines seitlichen Biegens in der Ebene der Breite B einen vorbestimmten Biegeradius R und eine vorbestimmte Biegezonenlänge H

   aufweisen, **dadurch gekennzeichnet, dass** für jeden der Teilleiter ($3_j$)
   - der Biegeradius R größer als das 100-Fache der Breite B sowie
   - die Biegezonenlänge H größer als das 20-Fache der Breite B ist

   und dass Mittel zur Fixierung der Teilleiter $3_j$ untereinander vorgesehen sind.

2. Verbundsupraleiter nach Anspruch 1, **gekennzeichnet durch** Teilleiter ($3_j$) mit einem Biegeradius R von mindestens dem 150-Fachen der Breite B.

3. Verbundsupraleiter nach Anspruch 1 oder 2, **gekennzeichnet durch** Teilleiter ($3_j$) mit einer Biegezonenlänge H von mindestens dem 50-Fachen der Breite B.

4. Verbundsupraleiter nach einem der vorangehenden Ansprüche, **gekennzeichnet durch** eine Zusammenfassung von Teilleitern ($3_j$) mit gleichem Aufbau.

5. Verbundsupraleiter nach einem der vorangehenden Ansprüche, **gekennzeichnet durch** Fixierungsmittel in Form von Verklebungen oder Verlötungen der Teilleiter ($3_j$) untereinander oder vorzugsweise **durch** eine Bandagierung oder Umspinnung.

6. Verbundsupraleiter nach Anspruch 5, **gekennzeichnet durch** eine für ein Imprägniermittel oder ein Kühlmittel durchlässige oder saugfähige Bandagierung oder Umspinnung.

7. Verbundsupraleiter nach einem der vorangehenden Ansprüche, **gekennzeichnet durch** Teilleiter ($3_j$) mit einem Verhältnis ihrer Breite B zur jeweiligen Leiterdicke D zwischen 5 und 40, vorzugsweise zwischen 10 und 20.

8. Verbundsupraleiter nach einem der vorangehenden Ansprüche, **dadurch gekennzeichnet, dass** zumindest einige seiner Teilleiter ($3_j$) gegenseitig elektrisch isoliert sind.

**9.** Verwendung des Verbundsupraleiters nach Anspruch 8 in einer energietechnischen Einrichtung mit Wechselstrombetrieb.

**10.** Verwendung nach Anspruch 9 in einem Transformator oder einer elektrischen Maschine.

**11.** Vorrichtung zur Herstellung des Verbundsupraleiters nach einem der Ansprüche 1 bis 8, **gekennzeichnet durch** Mittel zu einem reusenartigen Zusammenführen der einzelnen Teilleiter ($3_j$) von Vorratsspulen (12, 13) über einen Biegebereich und einen Führungsbereich in einer Verroebelungszone (17) derart, dass die Leiterquerschnittslage zumindest weitgehend konstant bleibt, und **durch** Mittel zum Transport des nunmehr verroebelten Aufbaus (25) über eine Vorschubeinheit (20) und einen Fixierungsbereich (21) in eine Aufwickelspule (23).

**12.** Vorrichtung nach Anspruch 11, **dadurch gekennzeichnet, dass** die Vorratsspulen (12, 13) an einer Drehscheibe (11) drehbeweglich befestigt sind.

**13.** Vorrichtung nach Anspruch 11 oder 12, **dadurch gekennzeichnet, dass** die Zuführung der Teilleiter ($3_j$) in die Verroebelungszone (17) mittels einer rotierenden Schlitzführungsscheibe (15) erfolgt.

**14.** Vorrichtung nach einem der Ansprüche 11 bis 13, **gekennzeichnet durch** eine Verroebelungszone (17) mit feststehenden Führungselementen (18) und einem Roebelkanal (19).

**Claims**

**1.** Fully transposed composite superconductor having an at least approximately rectangular cross section, which contains a number of conductor elements which are combined in the form of a transposed conductor, so-called Roebel bar, and which each have

- an at least approximately rectangular cross section with a width B,
- at least one conductor core composed of a high $T_c$ superconductor material in a matrix and/or sheath composed of normally conductive material,
as well as
- with respect to lateral bending in the plane of the width B, a predetermined bending radius R and a predetermined bending zone length H,

**characterized**
**in that**, for each of the conductor elements ($3_j$),

- the bending radius R is greater than 100 times the width B and
- the bending zone length H is greater than 20 times the width B,

and **in that** means are provided for fixing the conductor elements $3_j$ to one another.

**2.** Composite superconductor according to Claim 1, **characterized by** conductor elements ($3_j$) having a bending radius R of at least 150 times the width B.

**3.** Composite superconductor according to Claim 1 or 2, **characterized by** conductor elements ($3_j$) having a bending zone length H of at least 50 times the width B.

**4.** Composite superconductor according to one of the preceding Claims, **characterized by** a combination of conductor elements ($3_j$) with the same construction.

**5.** Composite superconductor according to one of the preceding Claims, **characterized by** fixing means in the form of adhesive joints or soldered joints between the conductor elements ($3_j$), or preferably by a binding or braiding.

**6.** Composite superconductor according to Claim 5, **characterized by** a binding or braiding which is permeable or absorbent for an impregnation agent or a cooling agent.

**7.** Composite superconductor according to one of the preceding Claims, characterize by conductor elements ($3_j$) having

a ratio of their width B to the respective conductor thickness D of between 5 and 40, preferably of between 10 and 20.

8. Composite superconductor according to one of the preceding Claims, **characterized in that** at least some of its conductor elements ($3_j$) are electrically insulated from one another.

9. Use of the composite superconductor according to Claim 8 in a power device operated with alternating current.

10. Use according to Claim 9 in a transformer or an electrical machine.

11. Apparatus for production of the composite superconductor according to one of Claims 1 to 8, **characterized by** means for joining the individual conductor elements ($3_j$) from supply spools (12, 13) together, in a pyramid shape, over a bending region and a guide region in a transposition zone (17), such that the conductor cross-section position remains at least largely constant, and by means for transport of the structure (25), which is now transposed, via a feed unit (20) and a fixing region (21) to a take-up spool (23).

12. Apparatus according to Claim 11, **characterized in that** the supply spools (12, 13) are mounted on a rotating disc (11) such that they can rotate.

13. Apparatus according to Claim 11 or 12, **characterized in that** the conductor elements ($3_j$) are supplied in the transposition zone (17) by means of rotating slotted guide disc (15).

14. Apparatus according to one of Claims 11 to 13, **characterized by** a transposition zone (17) having stationary guide elements (18) and a transposition channel (19).

## Revendications

1. Supraconducteur composite transposé entièrement, ayant une section transversale au moins à peu près rectangulaire et qui comporte plusieurs conducteurs partiels rassemblés à la manière d'un barreau de Roebel et ayant respectivement

   - une section transversale au moins à peu près rectangulaire d'une largeur B,
   - au moins une âme conductrice en un matériau supraconducteur à $T_c$ haute dans une matrice et/ou un enrobage en matériau normalement conducteur,
   ainsi que
   - pour ce qui concerne une flexion latérale dans le plan de la largeur B, un rayon R de courbure déterminé à l'avance et une longueur H de zone de courbure déterminée à l'avance,

   **caractérisé en ce que**, pour chacun des conducteurs ($3_j$) partiels,

   - le rayon R de courbure est plus grand que 100 fois la largeur B,
   ainsi que
   - la longueur H de la zone de courbure est plus grande que 20 fois la largeur B,

   et **en ce qu'**il est prévu des moyens d'immobilisation des conducteurs ($3_j$) partiels entre eux.

2. Supraconducteur composite suivant la revendication 1, **caractérisé par** des conducteurs ($3_j$) partiels ayant un rayon R de courbure représentant au moins 150 fois la largeur B.

3. Supraconducteur composite suivant la revendication 1 ou 2, **caractérisé par** des conducteurs ($3_j$) partiels ayant une longueur H de zone de courbure représentant au moins 50 fois la largeur B.

4. Supraconducteur composite suivant l'une des revendications précédentes, **caractérisé par** une réunion de conducteurs ($3_j$) partiels de même structure.

5. Supraconducteur composite suivant l'une des revendications précédentes, **caractérisé par** des moyens d'immobilisation sous la forme de collures ou de brasures des conducteurs ($3_j$) partiels entre eux ou, de préférence, par un bandage ou un guipage.

**6.** Supraconducteur composite suivant la revendication 5, **caractérisé par** un bandage ou un guipage perméable à un agent d'imprégnation ou à un fluide de refroidissement ou apte à l'aspirer.

**7.** Supraconducteur composite suivant l'une des revendications précédentes, **caractérisé par** des conducteurs ($3_j$) partiels ayant un rapport de leur largeur B à leur épaisseur D respective de conducteur compris entre 5 et 40, de préférence entre 10 et 20.

**8.** Supraconducteur composite suivant l'une des revendications précédentes, **caractérisé en ce qu'**au moins certains de ces conducteurs ($3_j$) partiels sont isolés mutuellement du point de vue électrique.

**9.** Utilisation du supraconducteur composite suivant la revendication 8 dans un dispositif en technique des courants forts fonctionnant en courant alternatif.

**10.** Utilisation suivant la revendication 9 dans un transformateur ou dans un moteur électrique.

**11.** Dispositif de fabrication d'un supraconducteur composite suivant l'une des revendications 1 à 8, **caractérisé par** des moyens de réunion en forme de nasses des divers conducteurs ($3_j$) partiels de bobines (12, 13) de réserve sur une partie de flexion et une partie de courbure dans une zone (17) de transposition, de façon à ce que la position de la section transversale des conducteurs reste au moins dans une grande mesure constante, et par des moyens de transport de la structure (25) maintenant transposée par une unité (20) d'avance et une partie (21) d'immobilisation dans une bobine (23) d'envidage.

**12.** Dispositif suivant la revendication 11, **caractérisé en ce que** les bobines (12, 13) de réserve sont fixées de manière à être mobiles en rotation sur un disque (11) tournant.

**13.** Dispositif suivant la revendication 11 ou 12, **caractérisé en ce que** l'envoi des conducteurs ($3_j$) partiels dans la zone (17) de transposition s'effectue au moyen d'un disque (15) de guidage à fente qui est tournant.

**14.** Dispositif suivant l'une des revendications 11 à 13, **caractérisé par** une zone (17) de transposition ayant des éléments (18) de guidage fixes et un canal (19) de Roebel.

FIG 1

EP 1 256 159 B1

**FIG 2**

**FIG 3**

$$H \approx 2\sqrt{r \times k} \quad \text{mit } k \approx B \ (<r)$$

**FIG 4**

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2736157 B2
- WO 9639705 A
- GB 1572236 A
- US 4611390 A
- DE PS277012 C
- EP 0407709 A

**In der Beschreibung aufgeführte Nicht-Patentliteratur**

- *IEEE Transactions on Applied Superconductivity,* Juli 1999, vol. 9 (2), 111-121
- *IEEE Transactions on Applied Superconductivity,* Juni 1997, vol. 7 (2), 958-961
- *IEEE Transactions on Applied Superconductivity,* Juli 1997, vol. 7 (2), 298-301
- *IEEE Transactions on Applied Superconductivity,* Juni 1999, vol. 9 (2), 2480-2485